# FASCICULE DE BREVET EUROPEEN

(11) **EP 2 700 133 B1**
(45) Date de publication et mention de la délivrance du brevet: **14.10.2015**
(21) Numéro de dépôt: 12717094.2
(22) Date de dépôt: 19.04.2012
(51) Int. Cl.: H01S 5/024, H01S 5/32, H01S 5/34, H01S 3/08, H01S 5/022, H01S 5/14, B82Y 20/00

(54) **DISPOSTIF LASER D'EMISSION D'ONDES DANS LE DOMAINE DES TERAHERTZ**
LASERVORRICHTUNG ZUR EMISSION VON WELLEN IM TERAHERTZBEREICH
LASER DEVICE FOR EMITTING WAVES IN THE TERAHERTZ RANGE

(30) Priorité: 19.04.2011 FR 1153384
(43) Date de publication de la demande: 26.02.2014
(73) Titulaire: Centre National de la Recherche Scientifique (CNRS), 75016 Paris (FR); Université Montpellier 2 Sciences et Techniques, 34000 Montpellier (FR)
(72) Inventeur: KNAP, Wojciech, F-34980 Saint Gely Du Fesc (FR); KLIMENKO, Oleg, Moscou 119146 (RU); MITYAGIN, Yuri, Moscou 119311 (RU); SOLIGNAC, Pierre, F-34130 Mudaison (FR)
(74) Mandataire: Regimbeau
(86) Numéro de dépôt international: PCT/EP2012/057106
(87) Numéro de publication internationale: WO 2012/143410

(56) Documents cités:
- US-A- 5 784 397
- US-A- 6 011 810
- KLIMENKO O A ET AL: "Terahertz wide range tunable cyclotron resonance p-Ge laser", JOURNAL OF PHYSICS: CONFERENCE SERIES, INSTITUTE OF PHYSICS PUBLISHING, BRISTOL, GB, vol. 193, no. 1, 1 novembre 2009 (2009-11-01), page 12064, XP020170423, ISSN: 1742-6596
- CHAMBERLIN D R ET AL: "Narrow linewidth intervalence-band emission from germanium terahertz lasers", APPLIED PHYSICS LETTERS, AIP, AMERICAN INSTITUTE OF PHYSICS, MELVILLE, NY, US, vol. 83, no. 1, 7 juillet 2003 (2003-07-07), pages 3-5, XP012034985, ISSN: 0003-6951, DOI: 10.1063/1.1590422

## Description

La présente invention concerne un dispositif laser d'émission d'ondes dans le domaine des Térahertz.

La présente invention peut trouver de nombreuses applications. Elle peut s'appliquer notamment dans les domaines de l'imagerie médicale, de la sécurité (détection de métaux ou de gaz dans les aéroports, etc.). Elle peut aussi permettre des contrôles de qualité.

### PRESENTATION GENERALE DE L'ART ANTERIEUR

Les sources de rayonnement Térahertz sont des sources dont le signal de sortie présente une longueur d'onde dans le domaine de l'infrarouge lointain du spectre électromagnétique (300 GHz - 10 THz).

On connaît des sources de rayonnement Térahertz telles que les carcinotrons (ou *« BWO »* sigle de l'expression anglo-saxonne « *Backward Wave Oscillator »)* ou les Lasers à cascade quantique (ou *« QCL »* sigle de l'expression anglo-saxonne *« Quantum Cascade Laser »).*

Un carcinotron est un tube générateur de micro-ondes qui fonctionne grâce à l'interaction prolongée d'un faisceau électronique et d'une onde électromagnétique.

Un laser à cascade quantique est un laser à semi-conducteur apte à émettre une onde lumineuse en utilisant des transitions inter sous bandes dans des hétéro-structures à multiples puits quantiques. Ce type de laser permet théoriquement d'obtenir des rendements quantiques supérieurs à 1 par « recyclage » des porteurs. L'application d'un champ électrique permet à un électron, après avoir émis un premier photon dans un premier puits, de passer par effet tunnel dans un puits suivant, et ainsi de suite.

Des sources laser THz sont divulguées dans « Terahertz wide range tunable cyclotron resonance p-Ge laser » de Klimenko et al, Journal of Physics: Conference series, Institute of Publishing, Bristol GB, vol. 193, no. 1, 1 novembre 2009 (2009-11-01), page 12064, ainsi que dans US6,011,810 et US5,784,397.

Un des inconvénients des sources de rayonnement Térahertz existantes est qu'elles ne sont ni compactes, ni aisées à mettre en oeuvre hors d'un laboratoire.

Un autre inconvénient des sources de rayonnement Térahertz existantes est qu'elles ne permettent pas d'émettre un rayonnement couvrant l'ensemble des fréquences du domaine des Térahertz.

En effet, un carcinotron est apte à émettre un rayonnement dans des fréquences inférieures ou égales à 1.5THz. Un laser à cascade quantique est quant à lui apte à émettre un rayonnement dans des fréquences supérieures ou égales à 2.5THz. Les sources de rayonnement Térahertz existantes ne permettent donc pas d'émettre un rayonnement dans une gamme de fréquence comprise entre 1.5THZ et 2.5THz.

Un but de la présente invention est de proposer un dispositif laser compact.

Un autre but de l'invention est de proposer un dispositif laser apte à émettre une onde dans une gamme de fréquence comprise entre 0,5 THz et 5 THz, et préférentiellement comprise entre 1.2 et 2.8THz.

### PRESENTATION DE L'INVENTION

A cet effet l'invention propose un dispositif laser d'émission d'onde dans une gamme de fréquence dans le domaine des Térahertz, comprenant en combinaison :
- un guide d'onde s'étendant longitudinalement selon un axe A-A', le guide d'onde comprenant une extrémité proximale et une extrémité distale,
- une bobine supraconductrice coaxiale au guide d'onde et disposée au niveau de l'extrémité proximale du guide d'onde,
- un cristal p-Ge de germanium dopé p disposé à l'intérieur de la bobine de sorte que les spires de la bobine supraconductrice entourent au moins partiellement le cristal p-Ge,
- des moyens de refroidissement contenant un fluide de refroidissement à l'état liquide, la bobine supraconductrice et le cristal p-Ge étant disposés dans les moyens de refroidissement et le guide d'onde s'étendant partiellement à l'extérieur des moyens de refroidissement,
- des moyens pour éliminer le fluide de refroidissement à l'état liquide dans le guide d'onde, lesdits moyens comportant deux fenêtres transparentes au rayonnement lumineux dans le domaine des Térahertz au niveau des extrémités proximale et distale du guide d'onde.

Des aspects préférés mais non limitatifs du dispositif selon l'invention sont les suivants :
- les moyens pour éliminer le fluide de refroidissement à l'état liquide dans le guide d'onde en le remplaçant par le fluide de refroidissement à l'état gazeux,
- les moyens pour éliminer le fluide de refroidissement à l'état liquide dans le guide d'onde comprennent en outre un élément chauffant en contact thermique avec le guide d'onde pour éviter la condensation de fluide de refroidissement,
- les moyens pour éliminer le fluide de refroidissement à l'état liquide dans le guide d'onde comprennent un vide réalisé dans le guide d'onde,
- les fenêtres sont réalisées dans un matériau transparent dans le domaine des Térahertz tel que le quartz cristallin, le mylar, le téflon®, le ZnSe cristallin, le saphir le silicium haute pureté ou d'autres cristaux semi-conducteurs haute pureté,
- la fenêtre transparente au rayonnement lumineux positionnée au niveau de l'extrémité distale du guide d'onde est une lentille,
- le dispositif comprend en outre un résonateur comportant au moins deux miroirs déposés sur deux plaques respectives de cristal de germanium de haute pureté en contact avec le cristal p-Ge, le cristal p-Ge étant disposé entre les plaques de cristal germanium selon l'axe A-A' du guide d'onde,
- les miroirs sont dans un matériau choisit parmi le dioxyde de silicium SiO2 et le germanium de haute pureté,
- le miroir le plus éloigné du guide d'onde est sphérique,
- le dispositif comprend en outre une lentille convergente disposée à l'intérieur du guide d'onde de sorte que :
   o la distance entre ladite lentille et le résonateur soit la plus grande possible, et
   o le faisceau lumineux issu du résonateur ne vienne pas en contact avec les parois internes du guide d'onde,
- la distance focale de la lentille convergente est choisie de sorte que les rayons lumineux sortant de ladite lentille convergente ne viennent pas en contact avec les parois du guide d'onde,
- le guide d'onde comprend un tronc de cône divergent et un tube coaxial au tronc de cône divergent, le tube s'étendant au niveau de la grande base du tronc de cône, la petite base du tronc de cône divergent formant la première extrémité du guide d'onde,
- la bobine supraconductrice comprend au moins deux couches de spires, chaque spire d'une nouvelle couche étant positionnée dans un creux formé par deux spires adjacentes de la couche précédente.

### PRESENTATION DES FIGURES

D'autres caractéristiques, buts et avantages de la présente invention ressortiront encore de la description qui suit, laquelle est purement illustrative et non limitative et doit être lue en regard des dessins annexés sur lesquels :
- la figure 1 illustre schématiquement un mode de réalisation d'un dispositif laser,
- la figure 2a illustre schématiquement un mode de réalisation d'une bobine supraconductrice
- la figure 2b illustre l'uniformité du champ magnétique généré par la bobine illustrée à la figure 2a en fonction de la distance au noyau de la bobine,
- la figure 2c illustre le champ magnétique généré par la bobine illustrée à la figure 2a en fonction de l'intensité du courant appliqué à la bobine,
- la figure 3 illustre des domaines de rayonnement inter sous bande et par résonance cyclotron pour des orientation données de champs électrique E et magnétique B en fonction des valeurs de champs électrique E et magnétique B,
- la figure 4 illustre schématiquement un exemple de générateur de tension pour l'application du champ électrique E,
- la figure 5 illustre schématiquement un exemple de système optique.
- La figure 6 illustre schématiquement des moyens d'élimination de liquide de refroidissement d'un guide d'onde,
- La figure 7 illustre schématiquement un résonateur avec utilisation de miroirs en germanium de haute pureté.

### DESCRIPTION DE L'INVENTION

On va maintenant décrire plus en détail un mode de réalisation du dispositif selon l'invention en référence aux figures.

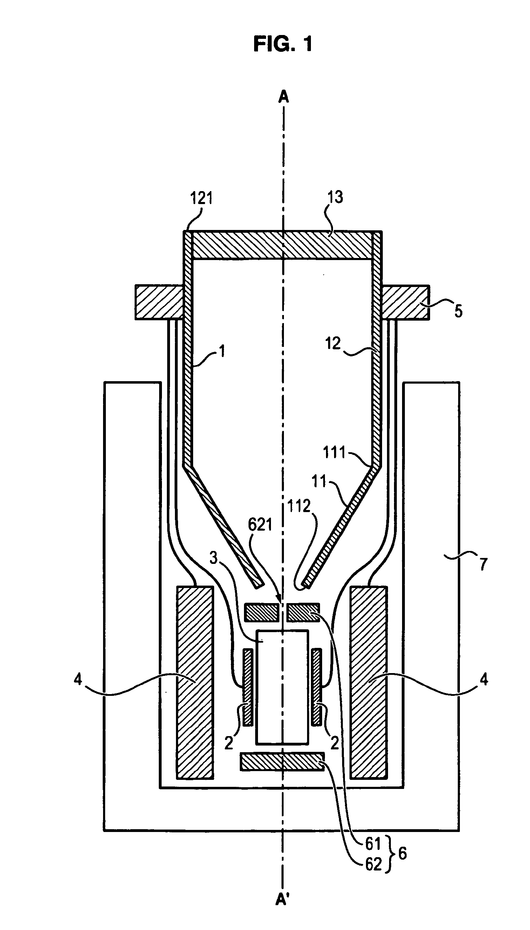

En référence à la figure 1 on a illustré un mode de réalisation du dispositif laser d'émission d'onde. Ce dispositif laser est apte à émettre une onde lumineuse dans une gamme de fréquences Térahertz par transitions des électrons dans la bande de valence.

Le dispositif laser comprend un guide d'onde 1, un élément de support 2, un cristal p-Ge 3, une bobine magnétique 4, des moyens de connexion électriquement conducteur 5, un résonateur 6, des moyens de refroidissement 7.

### Guide d'onde

Le guide d'onde 1 permet de diriger les ondes lumineuses émises par le cristal p-Ge 3 vers une sortie du dispositif laser.

Le guide d'onde 1 s'étend longitudinalement selon un axe A-A'. Le guide d'onde 1 est par exemple en acier inoxydable poli. Il comprend une extrémité proximale et une extrémité distale. L'extrémité proximale est plus proche du cristal p-Ge 3 que l'extrémité distale.

Dans un mode de réalisation illustré à la figure 1, le guide d'onde 1 comprend un tronc de cône divergent 11 et un tube coaxial 12 au tronc de cône divergent 11, le tube 12 s'étendant au niveau de la grande base 111 du tronc de cône 11 (i.e. la base du tronc de cône 11 ayant le plus grand diamètre). L'extrémité libre 121 du tube 12 forme la sortie du guide d'onde 1. La présence du tronc de cône 11 permet d'éviter des pertes de puissance grâce au rétrécissement graduel de guide d'onde 1. Le guide d'onde 1 peut comprendre une fenêtre 13 ' transparente aux ondes émises dans les fréquences Térahertz, par exemple en matériau Téflon®. Cette fenêtre 13 est disposée à la deuxième extrémité 121 du guide d'onde 1.

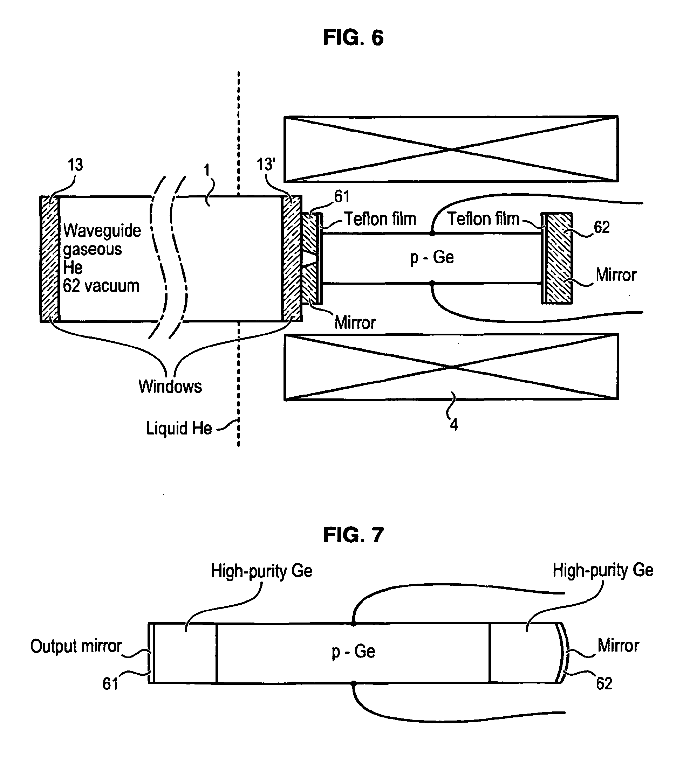

Dans un mode de réalisation illustré à la figure 6, le guide d'onde comprend des moyens pour éliminer le fluide de refroidissement à l'état liquide contenu dans celui-ci. Ceci permet d'améliorer la stabilité de génération d'impulsions du dispositif en limitant les risques de fluctuation de puissance d'une impulsion à l'autre.

En effet, dans le cas où le guide d'onde contient du fluide de refroidissement dans sa phase liquide, celui-ci peut se mettre en ébullition après une impulsion, la chaleur dégagée par le faisceau laser étant très importante. Dans ce cas, la puissance du faisceau laser généré lors d'une deuxième impulsion peut être différente de celle de la première impulsion, notamment du fait de la diffraction du faisceau laser sur la surface du fluide de refroidissement liquide en ébullition ou sur les bulles produite lors de son ébullition.

Les moyens pour éliminer le fluide de refroidissement liquide dans le guide d'onde peuvent comprendre deux fenêtres transparentes au rayonnement lumineux dans le domaine des Térahertz. Ces fenêtres sont par exemple positionnées au niveau des extrémités distale et proximale du guide d'onde. Les fenêtres transparentes peuvent être collées aux extrémités du guide d'onde pour rendre le guide d'onde étanche. Dans le cas où le fluide de refroidissement est de l'hélium, on prendra soin de choisir une colle résistante à l'hélium.

Avantageusement, le guide d'onde étanche ainsi obtenu peut être rempli de fluide de refroidissement à l'état gazeux. Ceci permet d'éliminer le fluide de refroidissement à l'état liquide dans le guide d'onde. Dans ce cas, on peut prévoir un élément de chauffage en contact thermique avec le guide d'onde pour chauffer le guide d'onde afin de maintenir gazeux le fluide de refroidissement contenu dans le guide d'onde.

En variante, on peut réaliser un vide d'air à l'intérieur du guide d'onde étanche. Ceci permet également d'éviter la présence de fluide de refroidissement en phase liquide.

### Elément de support

L'élément de support 2 est destiné à recevoir le cristal p-Ge 3. L'élément de support 2 comprend des contacts électriques pour la génération d'un champ électrique E à travers le cristal p-Ge 3.

L'élément de support 2 est connecté à une première extrémité 112 du guide d'onde.

En référence à la figure 1, l'élément de support 2 est fixé à la petite base 112 du cône divergent 11 (i.e. base du tronc de cône 11 de plus faible diamètre).

### Bobine magnétique supraconductrice

La bobine magnétique supraconductrice 4 permet de générer un champ magnétique B perpendiculaire au champ électrique E.

La bobine supraconductrice 4 est coaxiale au guide d'onde 1. Elle est disposée au niveau de l'élément de support 2. Plus précisément, la bobine 4 est positionnée autour du cristal p-Ge 3 de sorte que les spires de la bobine 4 entourent entièrement le cristal p-Ge 3. En d'autres termes, le cristal p-Ge 3 est disposé au noyau de la bobine 4 et s'étend le long de l'axe de révolution A-A' de la bobine supraconductrice 4.

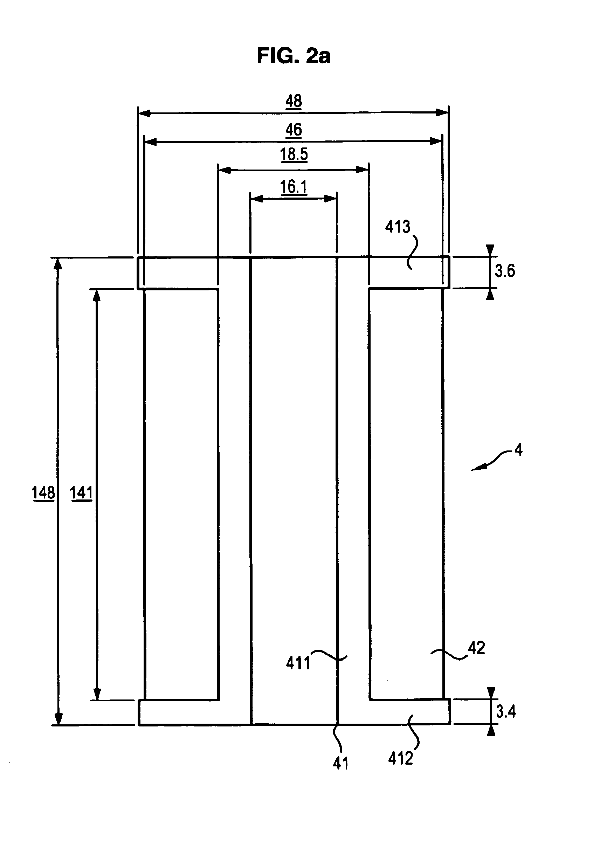

Un mode de réalisation de la bobine supraconductrice 4 est illustré à la figure 2a. La bobine supraconductrice 4 comprend une canette métallique 41 et un fil supraconducteur 42 enroulé autour de la canette métallique 41.

La canette métallique 41 est constituée d'une âme cylindrique creuse 411 et de deux flasques 412, 413 aux deux extrémités de l'âme cylindrique 411. Un canal cylindrique de diamètre 16.1 mm s'étend le long de l'axe de révolution de l'âme 411. Le diamètre du canal est prévu pour permettre le passage de l'élément de support 2 et du cristal p-Ge 3 (dont le diamètre est de l'ordre de 15.5 mm) à l'intérieur de la canette métallique 41. L'âme 411 sur laquelle le fil supraconducteur 42 est destiné à être enroulé présente un diamètre extérieur de 18.5mm et une longueur de 141 mm.

Le fil supraconducteur 42 présente un diamètre de 0.33mm. Ce fil 42 peut être composé d'une pluralité de filaments supraconducteurs. Par exemple, le fil supraconducteur 42 peut être composé de 54 filaments, chaque filament étant constitué de Niobium Titane (NbTi) et étant recouvert d'une couche de cuivre avec un rapport Cu/NbTi = 1.3.

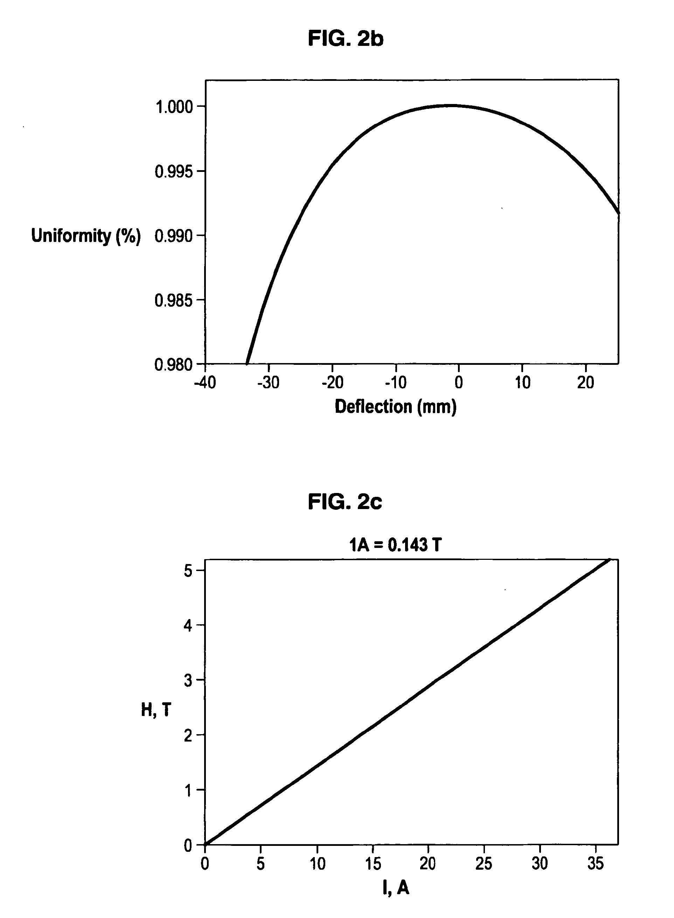

La bobine 4 comprend une pluralité de couches de spires. Dans le mode de réalisation illustré à la figure 2, la bobine 4 comprend quarante couches de fil supraconducteur 42, chaque couche comprenant entre 402 et 403 spires. La bobine 4 comprend également deux couches de protections disposées sur les quarante couches de fil supraconducteur 42. Le fil 42 est enroulé sur la canette métallique 41 selon une méthode dite *« d'enroulement en triangle »* dans laquelle chaque tour d'une nouvelle couche est positionné dans un creux formé par deux spires adjacentes de la couche précédente.

L'ensemble de la bobine 4 est inscrite dans un cylindre de hauteur égale à 148mm et de diamètre égal à 48mm.

Les figures 2b et 2c illustrent les principales caractéristiques mesurées de la bobine 4. La figure 2b illustre l'uniformité du champ magnétique en fonction de la distance au centre de la bobine. La figure 2c illustre la valeur du champ magnétique en fonction du courant appliqué à la bobine 4.

### Cristal p-Ge

Le cristal p-Ge 3 permet de générer une onde lumineuse dans une gamme de fréquences Térahertz.

Le matériau constituant le cristal p-Ge 3 est du germanium dopé p.

L'orientation cristallographique du cristal p-Ge relativement aux champs magnétique B et électrique E est choisie de sorte à permettre une commutation du laser entre deux régimes de rayonnement :
- le régime de rayonnement inter sous bande (ci-après dénommé « *ISB »,* sigle de l'expression anglo-saxonne « *inter subband* ») et
- le régime de rayonnement par résonance cyclotron (ci-après dénommé « *CR* », sigle de l'expression anglo-saxonne « *cyclotron resonance »).*

Avantageusement, la fréquence de l'onde lumineuse émise peut varier entre 1.2 et 2.8 Térahertz (40-90 cm⁻¹) avec une largeur spectrale inférieure à 6 GHz (0.2 cm⁻¹).

Comme décrit plus en détail dans la suite, cette commutation entre le régime de rayonnement ISB et le régime de rayonnement CR est obtenue en faisant varier la valeur et la direction des champs magnétique B et électrique E.

Dans un cristal de germanium dopé p, l'application de champs électrique E et magnétique B donnés permet l'accumulation de trous dans des sous-bandes de lumière divisées en niveaux de Landau. Deux types de rayonnement lumineux peuvent être générés en fonction des valeurs et orientations du champ électrique E et du champ magnétique B par rapport aux axes cristallographiques du cristal.

Le premier régime de rayonnement - à savoir le régime inter sous bandes (ISB)-est induit par la transition des trous des sous bandes de valence de trous légers (connu sous le nom de *« light hole subband »)* vers les sous bandes de valence de trous lourds (connu sous le nom de *« heavy hole subband »).* Ce premier mode de rayonnement intervient lorsque :
- le champ magnétique B est parallèle au plan cristallin [110] du cristal de p-Ge, et
- le champ électrique E est sensiblement parallèle à l'axe cristallin [1-10] dans le plan cristallin (110).

Le deuxième régime de rayonnement - à savoir le régime de résonance cyclotron (CR) - est induit par la transition des trous entre les niveaux de Landau et les sous bandes de valence de trous légers. Ce deuxième mode de rayonnement intervient lorsque :
- le champ magnétique est parallèle à l'axe cristallin [110], et
- le champ électrique forme un angle compris entre 50 et 90° avec l'axe cristallin [1-10] dans le plan cristallin (110).

Le régime de rayonnement CR devient possible grâce à des processus de diffusion et d'interaction avec la sous bande de valence de trous lourds qui amènent à une inversion de la population et à une non-équidistance entre les niveaux de Landau dans la sous bande de valence de trous légers. L'homme du métier appréciera que la forte anisotropie de la masse effective des trous lourds influence la diffusion des trous depuis la sous bande de valence de trous légers vers la sous bande de valence de trous lourds.

L'orientation cristallographique (relativement aux champs électrique E et magnétique B) et la concentration des accepteurs déterminent les domaines de rayonnement ISB et CR en fonction des valeurs de champs électrique et magnétique appliquées.

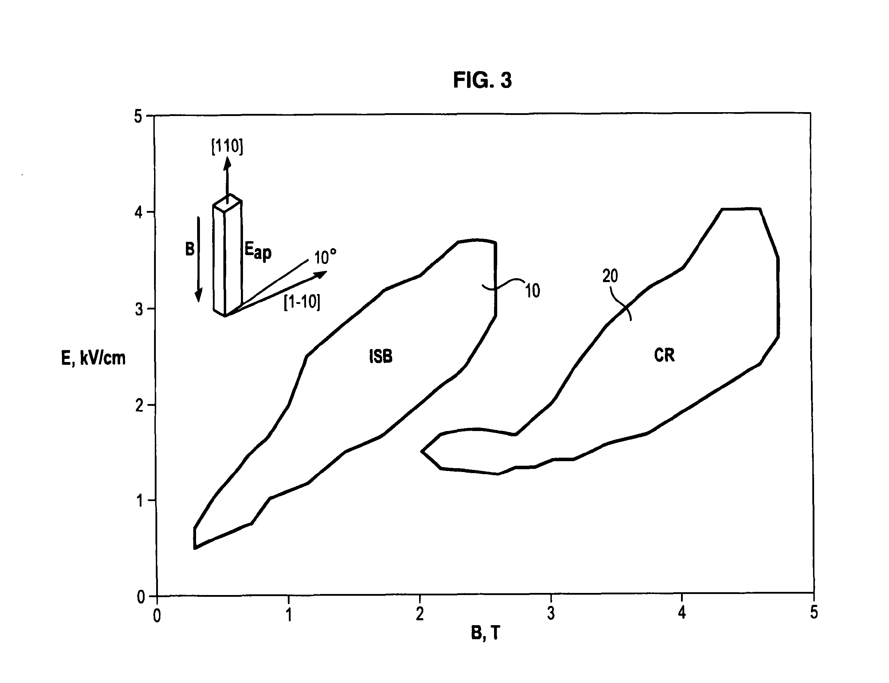

La figure 3 illustre les domaines de rayonnement ISB 10 et CR 20 en fonction des valeurs de champs électrique E et magnétique B appliqués pour un cristal de germanium dopé p en utilisant des accepteurs de gallium (N_{Ga} = 7.10¹³, dimensions cristal = 3x5x50 mm³), le champ magnétique étant parallèle à l'axe cristallin [110] et le champ électrique formant un angle de 10° avec l'axe cristallin [1-10].

L'orientation cristallographique choisie (i.e. B parallèle à l'axe cristallin [110] et E formant un angle de 10° avec l'axe cristallin [1-10]) permet d'obtenir l'émission d'une onde lumineuse dans le domaine CR. La fréquence de l'onde lumineuse est comprise entre 1.2 THz et 2.8 THz pour des valeurs de champ magnétique B comprises entre 2 et 4.8 Teslas. A des valeurs de champs magnétiques inférieures en polarité opposée, le cristal p-Ge génère une onde lumineuse dans le domaine ISB.

Dans le domaine CR, le cristal p-Ge 3 génère une onde lumineuse ayant une largeur de ligne de 6GHZ (0.2cm-1). Dans le domaine ISB, le cristal p-Ge 3 génère une onde lumineuse présentant une puissance 10 fois supérieure à celle de l'onde lumineuse émise dans le domaine CR. Toutefois, la largeur de ligne de l'onde lumineuse émise est également supérieure (300-600GHz, soit 10-20 cm⁻¹). Le fait de pouvoir commuter entre les deux régimes de rayonnement permet donc une adaptation du dispositif laser à différentes applications.

Avantageusement, l'orientation du champ électrique appliqué Eₐₚ peut être choisie pour prendre en compte le champ Hall E_{H}. Pour un champ magnétique compris entre 2 et 4.5 Teslas et des dimensions donnée de cristal (par exemple 3x5(selon Eₐₚ) x50(selon B) mm³) le champ Hall E_{H} prend des valeurs du même ordre de grandeur que le champ électrique appliqué Eₐₚ. Ceci induit l'obtention d'un champ électrique résultant Eₜₒₜ = E_{H} + Eₐₚ formant un angle compris entre 40 et 55° par rapport à l'axe cristallin [1-10].

Pour un champ électrique appliqué égal à 20°, le champ électrique résultant Eₜₒₜ = E_{H} + Eₐₚ présente un angle de 60...75° (ou -20...-35° selon la polarité du champ magnétique B) avec l'axe cristallin [1-10].

De préférence, on choisira d'appliquer un champ électrique Eₐₚ formant un angle avec l'axe cristallin [1-10] compris entre 10 et 35°.

Comme mentionné ci-dessus, la concentration en agent dopant influence également les processus de diffusion. Afin d'obtenir les deux régimes de rayonnement ISB et CR, on utilise un cristal de germanium dopé par du gallium à une concentration de N_{A} = 7.10¹³ cm⁻³. Le cristal présente une forme parallélépipédique de dimensions 3x6x50mm³ ou 3x6x30 mm³. Les faces du cristal p-Ge 3 sont polies. Ceci permet au cristal de générer une onde lumineuse. Deux des six faces du cristal p-Ge 3 (les faces de dimensions 3x50/3X30) sont recouvertes d'une couche d'indium In pour augmenter la conductivité électrique du cristal. Le cristal est positionné de sorte que sa plus grande dimension s'étende selon l'axe de la bobine supraconductrice 4.

### Moyens de connexion

Les moyens de connexion électrique 5 permettent de relier électriquement l'élément de support 2 et à la bobine supraconductrice 4 à un (ou plusieurs) générateur(s).

Par exemple la bobine supraconductrice 4 peut être connectée à un générateur de courant et l'élément de support 2 peut être connecté à un générateur de tension par l'intermédiaire des moyens de connexion 5.

Ces moyens de connexion 5 sont disposés à une deuxième extrémité 121 du guide d'onde 1.

En référence à la figure 1, les moyens de connexion 5 sont disposés au niveau de l'extrémité libre 121 du tube 12.

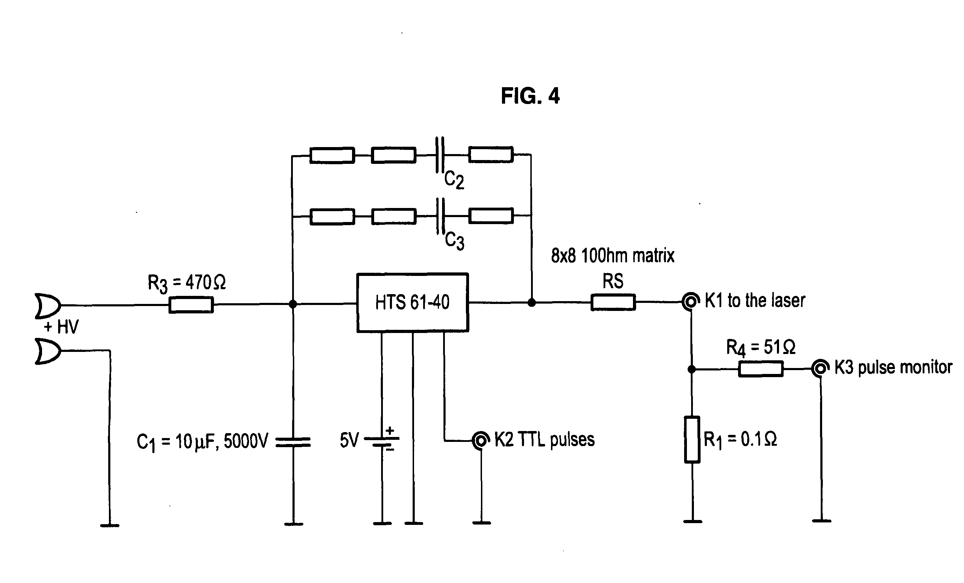

De préférence, le ou les générateurs sont choisis de sorte à permettre la génération :
- d'un champ magnétique compris entre 2 et 5 Teslas ; par exemple on choisira de connecter la bobine supraconductrice 4 à un générateur de courant apte à délivrer un courant électrique compris entre 0 et 100 Ampères (5 teslas nécessitent approximativement 35 Ampères),
- d'un champ électrique compris entre 2.5 et 4 kV/cm ; par exemple on choisira de connecter le cristal p-Ge 3 à un générateur de tension pulsée tel qu'illustré à la figure 4.

### Générateur de tension

En référence à la figure 4, nous avons illustré un exemple de générateur haute tension pulsée pouvant être connecté électriquement à l'élément de support 2 pour générer un champ électrique à l'intérieur du cristal p-Ge 3.

Ce générateur de tension est apte à générer des impulsions électriques rectangulaires courtes de 1µs à 2 µs, comprise entre 0.5kV et 2kV, et d'intensité comprise entre 50A et 200A.

Le principe de fonctionnement est le suivant. Une source haute tension se charge à travers une première résistance R3 et un premier condensateur C1. Un circuit logique TTL (logique transistor-transistor) ouvre à intervalle de temps court un commutateur ou transistor rapide haute tension (ou « HTS » sigle de l'expression anglo-saxonne « *high transistor switches »*), et le condensateur C1 se décharge à travers une résistance de sortie Rs et le cristal p-Ge. Comme l'impédance du cristal p-Ge est non linéaire, une partie des impulsions électriques est réfléchie vers le transistor rapide haute tension. La résistance de sortie Rs protège le transistor haute tension des impulsions de retour (connu sous le nom de *« flyback pulse* »). Les condensateurs C2, C3 connectés en série avec des résistances forment un filtre haute fréquence qui diminue le bruit sur les fronts montant et descendant des impulsions électriques rectangulaires.

### Résonateur

Le résonateur 6 permet d'augmenter (de l'ordre de 3 à 5 fois) la puissance de l'onde lumineuse émise par le cristal p-Ge 3.

Le résonateur 6 est disposé au niveau de l'élément de support 2.

Différents types de résonateurs 6 peuvent être utilisés.

Dans une variante de réalisation, le résonateur 6 est du type Perrot-Fabry. Le résonateur consiste en deux miroirs 61, 62 s'étendant dans des plans perpendiculaires à l'axe A-A' du guide d'onde 1.

Ces miroirs 61, 62 sont positionnés de part et d'autre du cristal p-Ge 3 selon l'axe A-A' du guide d'onde 1 de sorte que le cristal p-Ge 3 s'étend entre les deux miroirs 61, 62 formant le résonateur 6.

Le matériau constituant les miroirs 61, 62 du résonateur peut être métallique, par exemple du laiton. Dans ce cas, un film diélectrique (non représenté) tel qu'un film de Mylar peut être disposé entre le cristal p-Ge 3 et chaque miroir métallique 61, 62. Ceci permet d'isoler électriquement les miroirs 61, 62. Dans le mode de réalisation illustré à la figure 1, chaque miroir 61, 62 est séparé du cristal d'une distance de 10µm selon l'axe A-A' du guide d'onde 1.

Le matériau constituant les miroirs 61, 62 du résonateur 6 peut également être du dioxyde de silicium SiO₂, ou encore du germanium Ge de haute pureté. Dans ces cas, les faces externes (opposées au cristal) des miroirs en Ge ou en SiO₂ sont métallisées. Le Ge de haute pureté et le SiO₂ étant isolant électriquement à basses températures, les miroirs 61, 62 peuvent être directement en contact avec le cristal p-Ge 3.

Le miroir 62 le plus proche du guide d'onde 1 comprend une ouverture traversante 621 pour permettre le passage de l'onde lumineuse vers le guide d'onde 1. Dans le mode de réalisation illustré à la figure 1, l'ouverture traversante 621 présente un diamètre de 1.5mm.

Dans un mode de réalisation, les miroirs 61, 62 sont plans.

Dans un autre mode de réalisation, le miroir 61 le plus éloigné du guide d'onde 1 est sphérique. Ceci permet d'optimiser la composition de l'onde lumineuse émise par le cristal p-Ge en modes optiques.

Le miroir 62 le plus proche du guide d'onde peut être semi-transparent pour limiter les effets de diffraction susceptibles de perturber le faisceau laser de sortie.

Dans une variante de réalisation, les miroirs sont formés directement sur les faces de plaques de cristal de germanium de haute pureté en contact avec le cristal p-Ge. Plus précisément :
- un premier miroir est formé par dépôt sur la face d'un cristal de germanium en contact avec la face du cristal p-Ge la plus éloignée du guide d'onde,
- un deuxième miroir est formé par dépôt sur la face d'un cristal de germanium en contact avec la face du cristal p-Ge la plus proche du guide d'onde.

Les miroirs sont formés sur les faces des cristaux de germanium opposées aux faces en contact avec le cristal p-Ge. Ces cristaux de germanium sont positionnés sur le cristal p-Ge de sorte que les miroirs s'étendent perpendiculairement à l'axe A-A'.

Le germanium de haute pureté est un bon isolateur électrique et permet de protéger les miroirs des impulsions à haute tension générées pour produire le rayonnement lumineux dans le domaine des Terahertz.

L'utilisation de miroirs formés sur les faces externes de cristaux de germanium permet d'optimiser la puissance de sortie et la qualité optique du faisceau de sortie. En effet, il n'y a pas de cavité entre les surfaces réfléchissantes des miroirs et le cristal, ce qui diminue les pertes liées aux réflexions pouvant se produire dans une telle cavité.

L'utilisation de miroirs en forme soit sphérique soit plane (plate) sur les faces externes de cristaux de germanium permet d'optimiser la composition de faisceau en modes optiques.

### Moyens de refroidissement

Le dispositif laser comprend également des moyens de refroidissement 7 contenant un fluide de refroidissement à l'état liquide, tel que de l'hélium liquide, l'élément de support 2, le cristal p-Ge 3 et la bobine supraconductrice 4, une partie du guide d'onde 1 et le résonateur 6.

Ces moyens de refroidissement 7 sont avantageusement une bouteille d'hélium standard, par exemple un récipient RH 65 de Air liquide®.

En effet, la forme et les dimensions de l'élément de support 2, de la bobine supraconductrice 4 et du cristal p-Ge 3 permettent d'obtenir un dispositif laser suffisamment petit pour pouvoir introduire celui-ci dans une bouteille d'hélium standard.

Ceci permet d'obtenir un dispositif laser portable. On notera que les moyens de connexion électriquement conducteurs 5 s'étendent à l'extérieur de la bouteille d'hélium.

Ainsi, bien que l'ensemble comprenant le cristal p-Ge 3, l'élément de support 2, le résonateur 6 et la bobine 4 soient totalement contenu dans la bouteille d'hélium, une partie du guide d'onde 1 s'étend à l'extérieur de la bouteille d'hélium, de sorte que la quantité d'hélium dans le guide d'onde 1 peut varier entre ses extrémités proximale et distale. L'indice de réfraction de l'hélium variant en fonction de paramètres tels que la pression ou la densité, la variation de quantité d'hélium le long du guide d'onde 1 induit une variation de l'indice de réfraction de celui-ci le long dudit guide d'onde 1. Cette variation de l'indice de réfraction peut entrainer des perturbations telles que des variations de puissance et/ou de direction du faisceau lumineux à travers le guide d'onde 1.

Comme mentionné ci-dessus, l'extrémité distale du guide d'onde 1 peut comprendre une fenêtre 13 transparente aux ondes Térahertz pour homogénéiser la quantité d'hélium à l'intérieur du guide d'onde 11 afin d'éviter ces perturbations.

En variante, les extrémités proximale et distale du guide d'onde peuvent comprendre chacune une fenêtre transparente respective de sorte à former un guide d'onde étanche, le guide d'onde étant sous vide ou contenant du fluide de refroidissement en phase gazeuse.

### Système optique

Le guide d'onde 1 peut comprendre un système optique. Ce système optique permet la collimation de l'onde lumineuse émise par le cristal p-Ge 3. Avantageusement, le faisceau lumineux collimaté par le système optique peut être vertical ou horizontal.

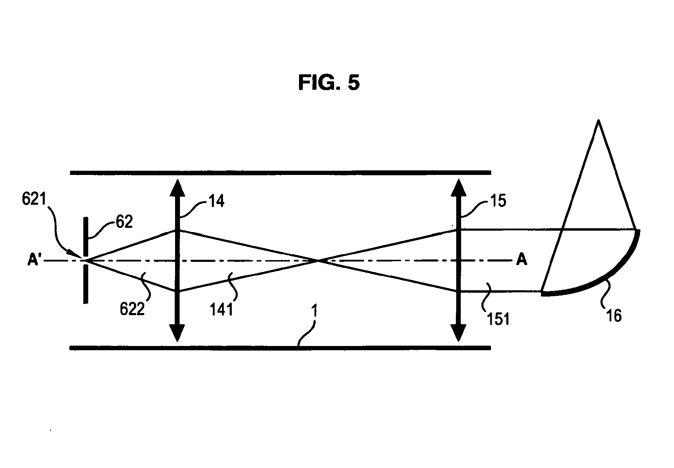

Le système optique peut comprendre une (ou plusieurs) lentille(s) et/ou un (ou plusieurs) miroir(s). Dans une variante de réalisation illustrée à la figure 5, le système optique comprend deux lentilles convergentes 14, 15 et un miroir parabolique 16.

Le miroir parabolique 16 est positionné à la sortie du guide d'onde 1 et permet d'orienter le faisceau lumineux issu du guide d'onde 1 perpendiculairement à l'axe A-A' du guide d'onde.

Une première lentille 15 est positionnée à la deuxième extrémité 121 du guide d'onde 1 (i.e. l'extrémité la plus éloignée de l'ensemble résonateur/élément de support/bobine). La première lentille 15 est choisie de sorte que les rayons lumineux 151 sortant de cette première lentille 15 sont parallèles. Cette première lentille 15 permet d'isoler le guide d'onde de l'air extérieur de sorte à homogénéiser le niveau d'hélium à l'intérieur du guide d'onde 1. Cette première lentille 15 peut donc remplacer la fenêtre 13 transparente aux ondes Térahertz.

Une deuxième lentille 14 est positionnée dans le guide d'onde 1. La distance entre le résonateur 6 et la deuxième lentille 14 (i.e. la plus proche de l'ensemble résonateur/élément de support/bobine) est choisie de sorte que :
- ladite lentille 14 soit la plus éloignée possible du résonateur 6, et
- le faisceau lumineux 622 issu du résonateur 6 ne vienne pas en contact avec les parois internes du guide d'onde 1.

Par exemple, la deuxième lentille 14 est positionnée dans le guide d'onde 1 à une distance de 100mm du résonateur 6. La distance focale de la deuxième lentille 14 est par ailleurs choisie de sorte que les rayons lumineux 141 sortant de cette deuxième lentille 14 ne viennent pas en contact avec les parois du guide d'onde 1 avant d'atteindre la première lentille 15. Ceci permet d'améliorer la qualité du faisceau laser de sortie.

### Principe de fonctionnement

Le principe de fonctionnement du dispositif laser décrit ci-dessus est le suivant.

Le générateur de tension alimente les connexions électriques de l'élément de support 2 de sorte à générer un champ électrique E. Le générateur de courant alimente la bobine supraconductrice 4 de sorte à générer un champ magnétique B. Une autre partie des ondes lumineuses émises par le cristal p-Ge 3 traverse le miroir 62 du résonateur 6 le plus proche du guide d'onde 1 au niveau de l'ouverture traversante 621 de celui-ci.

Ces ondes lumineuses se propagent dans le guide d'onde 1 et entrent en contact avec la deuxième lentille 14 du système optique. La deuxième lentille 14 focalise les ondes lumineuses dans le guide d'onde 1 de sorte à éviter que les ondes lumineuses ne viennent en contact avec les parois du guide d'onde 1. Les ondes lumineuses focalisées se propagent jusqu'à la première lentille 15 du système optique et traversent celui-ci. Les ondes lumineuses 151 en sorti de la première lentille 15 sont parallèles. Les ondes lumineuses parallèles 151 se propagent jusqu'au miroir parabolique 16 qui oriente ces ondes lumineuses perpendiculairement à l'axe A-A' du guide d'onde 1.

Le lecteur appréciera que de nombreuses modifications peuvent être apportées à l'invention telle que décrite ci-dessus sans sortir matériellement des enseignements du présent document. Par conséquent, toutes ces modifications sont destinées à être incorporées à l'intérieur de la portée des revendications jointes.

## Revendications

1. Dispositif laser d'émission d'onde dans une gamme de fréquence dans le domaine des Térahertz, **caractérisé en ce qu'**il comprend en combinaison :
- un guide d'onde (1) s'étendant longitudinalement selon un axe A-A', le guide d'onde comprenant une extrémité proximale et une extrémité distale,
- une bobine supraconductrice (4) coaxiale au guide d'onde (1) et disposée au niveau de l'extrémité proximale (112) du guide d'onde (1),
- un cristal p-Ge (3) de germanium dopé p disposé à l'intérieur de la bobine (4) de sorte que les spires de la bobine supraconductrice (4) entourent au moins partiellement le cristal p-Ge (3),
- des moyens de refroidissement (7) contenant un fluide de refroidissement à l'état liquide, la bobine supraconductrice (4) et le cristal p-Ge (3) étant disposés dans les moyens de refroidissement (7) et le guide d'onde (1) s'étendant partiellement à l'extérieur des moyens de refroidissement (7),
- des moyens pour éliminer le fluide de refroidissement à l'état liquide dans le guide d'onde, lesdits moyens comportant deux fenêtres (13, 13') transparentes au rayonnement lumineux dans le domaine des Térahertz au niveau des extrémités proximale et distale du guide d'onde.

2. Dispositif selon la revendication 1, dans lequel les moyens pour éliminer le fluide de refroidissement à l'état liquide dans le guide d'onde en le remplaçant par le fluide de refroidissement à l'état gazeux.

3. Dispositif laser selon la revendication 2, dans lequel les moyens pour éliminer le fluide de refroidissement à l'état liquide dans le guide d'onde comprennent en outre un élément chauffant en contact thermique avec le guide d'onde pour éviter la condensation de fluide de refroidissement.

4. Dispositif selon la revendication 1, dans lequel les moyens pour éliminer le fluide de refroidissement à l'état liquide dans le guide d'onde comprennent un vide réalisé dans le guide d'onde.

5. Dispositif selon l'une des revendications 1 à 4, dans lequel les fenêtres sont réalisées dans un matériau transparent dans le domaine des Térahertz tel que le quartz cristallin, le mylar, le téflon®, le ZnSe cristallin, le saphir le silicium haute pureté ou d'autres cristaux semi-conducteurs haute pureté.

6. Dispositif selon l'une des revendications 1 à 5, dans lequel la fenêtre transparente au rayonnement lumineux positionnée au niveau de l'extrémité distale du guide d'onde est une lentille (15).

7. Dispositif selon l'une quelconque des revendications 1 à 6, lequel comprend en outre un résonateur (6) comportant au moins deux miroirs (61, 62) déposés sur deux plaques respectives de cristal de germanium de haute pureté en contact avec le cristal p-Ge, le cristal p-Ge (3) étant disposé entre les plaques de cristal germanium selon l'axe A-A' du guide d'onde (1).

8. Dispositif selon la revendication 7, dans lequel les miroirs (61, 62) sont dans un matériau choisit parmi le dioxyde de silicium SiO2 et le germanium de haute pureté.

9. Dispositif selon l'une quelconque des revendications 7 ou 8, dans lequel le miroir (61) le plus éloigné du guide d'onde (1) est sphérique.

10. Dispositif selon l'une des revendications 7 à 9, lequel comprend en outre une lentille convergente (14) disposée à l'intérieur du guide d'onde de sorte que :
- la distance entre ladite lentille (14) et le résonateur (6) soit la plus grande possible, et
- le faisceau lumineux (622) issu du résonateur (6) ne vienne pas en contact avec les parois internes du guide d'onde (1).

11. Dispositif selon la revendication 10, dans lequel la distance focale de la lentille convergente (14) est choisie de sorte que les rayons lumineux (141) sortant de ladite lentille convergente (14) ne viennent pas en contact avec les parois du guide d'onde (1).

12. Dispositif selon l'une quelconque des revendications 1 à 11, dans lequel le guide d'onde (1) comprend un tronc de cône divergent (11) et un tube (12) coaxial au tronc de cône divergent (11), le tube (12) s'étendant au niveau de la grande base (111) du tronc de cône (11), la petite base (112) du tronc de cône divergent (11) formant la première extrémité du guide d'onde (1).

13. Dispositif selon l'une des revendications 1 à 12, dans lequel la bobine supraconductrice (4) comprend au moins deux couches de spires, chaque spire d'une nouvelle couche étant positionnée dans un creux formé par deux spires adjacentes de la couche précédente.

## Patentansprüche

1. Laservorrichtung zur Wellenlausstrahlung in einem Frequenzbereich der Terahertz **gekennzeichnet dadurch, dass** sie in Kombination umfasst:
- Einen Wellenleiter (1), der sich längs entsprechend einer Achse A-A' erstreckt, wobei der Wellenleiter ein proximales Ende und ein distales Ende umfasst,
- eine supraleitende, zum Wellenleiter (1) koaxiale Spule (4) am proximalen Ende (112) des Wellenleiters (1),
- einen p-dotierten Germaniumkristall p-Ge (3) in der Spule (4) derart, dass die Windungen der supraleitenden Spule (4) den Kristall p-Ge (3) zumindest teilweise umgeben,
- Kühlmittel (7) mit einer Kühlflüssigkeit in flüssigem Zustand, wobei sich die supraleitende Spule (4) und der Kristall p-Ge (3) in den Kühlmitteln (7) befinden und der Wellenleiter (1) sich teilweise außerhalb der Kühlmittel erstreckt (7),
- Mittel zur Beseitigung der Kühlflüssigkeit in flüssigem Zustand im Wellenleiter, wobei diese Mittel zwei transparente Fenster (13, 13') mit Lichtstrahlung im Terahertz-Bereich am proximalen und distalen Ende des Wellenleiters umfassen.

2. Vorrichtung gemäß Anspruch 1, in dieser die Mittel zur Beseitigung der Kühlflüssigkeit in flüssigem Zustand im Wellenleiter, wobei diese durch die Kühlflüssigkeit in gasförmigem Zustand ersetzt wird.

3. Laservorrichtung gemäß Anspruch 2, in der die Mittel zur Beseitigung der Kühlflüssigkeit in flüssigem Zustand im Wellenleiter unter anderem ein Element umfassen, das sich in thermischem Kontakt mit dem Wellenleiter erhitzt, um die Kondensation von Kühlflüssigkeit zu verhindern.

4. Vorrichtung gemäß Anspruch 1, in der die Mittel zur Beseitigung der Kühlflüssigkeit in flüssigem Zustand im Wellenleiter ein im Wellenleiter erzeugtes Vakuum umfassen.

5. Vorrichtung gemäß einem der Ansprüche 1 bis 4, in der die Fenster in einem transparenten Material im Terahertz-Bereich wie kristalliner Quarz, Mylar, Teflon®, kristallines ZnSe, Saphir, Silicium hoher Reinheit oder anderer halbleitender Kristalle hoher Reinheit ausgeführt werden.

6. Vorrichtung gemäß einem der Ansprüche 1 bis 5, in der das transparente Fenster mit Lichtstrahlung am distalen Ende des Wellenleiters eine Linse (15) ist.

7. Vorrichtung gemäß einem der Ansprüche 1 bis 6, die unter anderem einen Resonator (6) mit mindestens zwei Spiegeln (61, 62) jeweils an den Platten des Germaniumkristalls hoher Reinheit in Kontakt mit dem Kristall p-Ge umfasst, wobei sich der Kristall p-Ge (3) zwischen den Germaniumkristallplatten entsprechend der Achse A-A' des Wellenleiters (1) befindet.

8. Vorrichtung gemäß Anspruch 7, in der sich die Spiegel (61, 62) in einem unter Siliziumdioxid SiO2 und Germanium hoher Reinheit ausgewählten Material befinden.

9. Vorrichtung gemäß einem der Ansprüche 7 und 8, in der der am weitesten vom Wellenleiter (1) entfernte Spiegel (61) kugelförmig ist.

10. Vorrichtung gemäß einem der Ansprüche 7 bis 9, die unter anderem eine konvergente Linse (14) im Wellenleiter derart umfasst:
- Dass der Abstand zwischen dieser Linse (14) und dem Resonator (6) am größtmöglichsten ist, und
- dass die Lichtbündel (622) aus dem Resonator (6) nicht in Kontakt mit den Innenwänden des Wellenleiters (1) kommen.

11. Vorrichtung gemäß Anspruch 10, in der die Brennweite der konvergenten Linse (14) derart ausgewählt ist, dass die aus dieser konvergenten Linse (14) ausgehenden Lichtstrahlen (141) nicht in Kontakt mit den Wänden des Wellenleiters (1) kommen.

12. Vorrichtung gemäß einem der Ansprüche 1 bis 11, in der der Wellenleiter (1) einen divergenten Kegelstumpf (11) und ein zum divergenten Kegelstumpf (11) koaxiales Rohr (12) umfasst, wobei das Rohr (12) sich an der großen Grundlinie (111) des divergenten Kegelstumpfs (11) erstreckt und die kleine Grundlinie (112) des divergenten Kegelstumpfs (11) das erste Ende des Wellenleiters (1) bildet.

13. Vorrichtung gemäß einem der Ansprüche 1 bis 12, in der die supraleitende Spule (4) mindestens zwei Windungsschichten umfasst, wobei jede Windung einer neuen Schicht in einer von zwei angrenzenden Windungen der vorherigen Schicht gebildeten Höhlung positioniert ist.

## Claims

1. Laser wave emission device in a frequency range in the Terahertz domain, **characterised in that** it comprises in combination:
- a waveguide (1) extending longitudinally along an axis A-A', the waveguide comprising a proximal end and a distal end,
- a superconducting coil (4) coaxial with respect to the waveguide (1) and arranged at the proximal end (112) of the waveguide (1),
- a p-doped germanium p-Ge crystal (3) arranged inside the coil (4) such that the turns of the superconducting coil (4) surround at least partially the p-Ge crystal (3),
- cooling means (7) containing a coolant in the liquid state, the superconducting coil (4) and the p-Ge crystal (3) being arranged in the cooling means (7) and the waveguide (1) extending partially outside the cooling means (7),
- means for removing the coolant in the liquid state in the waveguide, said means comprising two windows (13, 13') transparent to light rays in the Terahertz domain at the proximal and distal ends of the waveguide.

2. Device according to claim 1, wherein the means for removing the coolant in the liquid state in the waveguide by replacing it by the coolant in the gaseous state.

3. Laser device according to claim 2, wherein the means for removing the coolant in the liquid state in the waveguide further comprise a heating element in thermal contact with the waveguide to prevent condensation of the coolant.

4. Device according to claim 1, wherein the means for removing the coolant in the liquid state in the waveguide comprise a vacuum created in the waveguide.

5. Device according to any of claims 1 to 4, wherein the windows are made of a transparent material in the Terahertz domain such as crystalline quartz, Mylar, Teflon®, crystalline ZnSe, sapphire, high-purity silicon and other high-purity semiconductor crystals.

6. Device according to any of claims 1 to 5, wherein the window transparent to light rays positioned at the distal end of the waveguide is a lens (15).

7. Device according to any of claims 1 to 6, which further comprises a resonator (6) comprising at least two mirrors (61, 62) deposited on two respective plates of high-purity germanium crystal in contact with the p-Ge crystal, the p-Ge crystal (3) being arranged between the germanium crystal plates along the axis A-A' of the waveguide (1).

8. Device according to claim 7, wherein the mirrors (61, 62) are made of a material chosen from silicon dioxide SiO2 and high-purity germanium.

9. Device according to any of claims 7 or 8, wherein the mirror (61) furthest from the waveguide (1) is spherical.

10. Device according to any of claims 7 to 9, which further comprises a converging lens (14) arranged inside the waveguide such that:
- the distance between said lens (14) and the resonator (6) is the greatest possible, and
- the light beam (622) from the resonator (6) does not come into contact with the inner walls of the waveguide (1).

11. Device according to claim 10, wherein the focal length of the converging lens (14) is chosen such that the light rays (141) emerging from said converging lens (14) do not come into contact with the walls of the waveguide (1).

12. Device according to any of claims 1 to 11, wherein the waveguide (1) comprises a divergent truncated cone (11) and a tube (12) coaxial with respect to the divergent truncated cone (11), the tube (12) extending at the level of the large base (111) of the truncated cone (11), the small base (112) of the divergent truncated cone (11) forming the first end of the waveguide (1).

13. Device according to any of claims 1 to 12, wherein the superconducting coil (4) comprises at least two layers of turns, each turn of a new layer being positioned in a hollow formed by two adjacent turns of the preceding layer.
